# EUROPEAN PATENT APPLICATION

(11) **EP 3 389 179 A1**
(43) Date of publication of application: **17.10.2018**
(21) Application number: 17738194.4
(22) Date of filing: 13.01.2017
(51) Int. Cl.: H02S 30/20

(54) **FOLDABLE SOLAR BATTERY PACK**

(30) Priority: 13.01.2016 CN 201620032521 U
(71) Applicant: Beijing Apollo Ding Rong Solar Technology Co., Ltd., Beijing 100176 (CN)
(72) Inventor: XIA, Ping, Beijing 100176 (CN); WANG, Jicun, Beijing 100176 (CN); CHENG, Xiaolong, Beijing 100176 (CN); MA, Siyao, Beijing 100176 (CN); WANG, Yuefu, Beijing 100176 (CN); GAO, Yanlei, Beijing 100176 (CN); ZHANG, Yu, Beijing 100176 (CN)
(74) Representative: D'Halleweyn, Nele Veerle Trees Gertrudis
(86) International application number: PCT/CN2017/071106
(87) International publication number: WO 2017/121381

(57) **Abstract**

A foldable solar battery pack includes: a foldable pack body capable of being expanded into a rectangular shape, and formed by a first flexible protection film layer through packaging; a thin-film solar cell assembly including at least one thin-film solar cell arranged along a lengthwise direction of an inner surface of the expanded foldable pack body, wherein a gap is present between any two adjacent thin-film solar cells and forms a fold line; and a power output device and a wire; wherein a second flexible protection film layer is packaged on the thin-film solar cell assembly, and includes, sequentially and from the top to the bottom, an upper surface layer and an adhesive bonding layer; a third flexible protection film layer is packaged in the remaining area on the inner surface of the expanded foldable pack body other than the area taken up by the thin-film solar cell assembly, and includes, sequentially and from the top to the bottom, an upper surface layer, an adhesive bonding layer, and a lower surface layer; and the first flexible protection film layer includes, sequentially and from the top to the bottom, an adhesive bonding layer and a lower surface layer.

## Description

### Technical Field

The application relates to, but is not limited to, the technical field of semiconductors, in particular to a foldable solar battery pack.

### Background

Recently a solar charger in the market generally includes a solar photovoltaic assembly and a voltage output unit. Such solar charger converts solar radiation into electrical energy through the solar photovoltaic assembly, and then generates stable direct current or alternating current output through a current conversion device to supply power to various loads. For example, Chinese patent document CN103997090A discloses a foldable solar mobile power source which includes a solar panel, a rotating shaft, a housing, a storage battery, a photovoltaic charging controller and an AC power socket, wherein the solar panel is movably connected with the housing through the rotating shaft; the solar panel is electrically connected with the photovoltaic charging controller and the storage battery sequentially; the storage battery and the photovoltaic charging controller are installed in the housing; and the AC power socket is positioned on the side wall of the housing. The solar panel can rotate by means of the rotating shaft. When being charged with solar power, the solar panel is rotated to the outside of the housing, and when the charging is finished and the charger is in use, the solar panel can be rotated into an empty groove inside the housing, thus effectively avoiding damage to the solar panel.

The existing problem is that the solar mobile power source includes a solar panel, a rotating shaft, a housing, a storage battery, a photovoltaic charging controller and an AC power socket, which causes the solar mobile power source complex in structure, high in manufacturing cost and large in volume. In addition, the conversion efficiency of the solar panels which convert solar power to electric energy is relatively low. Also, the solar photovoltaic panels are generally inflexible or the flexibility thereof is low, which causes the panels cannot be folded or the solar cell is easily damaged after the panel being folded. Moreover, the weight of solar photovoltaic panel is relatively high, which makes the solar mobile power source inconvenient to carry with.

### Summary

Therefore, in order to solve the problems, i.e., the solar charger is complex in structure and large in volume, cannot be folded, or the solar cell is easily damaged after the solar charger being folded, which cause the solar charger inconvenience to carry with and low efficiency in converting solar energy into electric energy, this application provides a foldable solar battery pack which is simple in structure, small in volume, foldable and high efficiency in converting solar energy into electric energy.

An embodiment of the application provides a foldable solar battery pack including:
a foldable pack body which is rectangular in shape after being expanded and formed by a first flexible protection film layer through packaging;
a thin-film solar cell assembly including at least one thin-film solar cell arranged along a lengthwise direction of the inner surface of the expanded foldable pack body, wherein a gap is present between any two adjacent thin-film solar cells and forms a fold line;
a power output device configured to output the electric energy converted by the thin-film solar cell assembly; and
a wire configured for connecting the thin-film solar cells and for connecting the thin-film solar cell assembly to the power output device;
wherein a second flexible protection film layer is packaged on the thin-film solar cell assembly and includes, sequentially and from the top to the bottom, an upper surface layer and an adhesive bonding layer, and a third flexible protection film layer is packaged on the remaining area of the inner surface of the expanded foldable pack body expect for the area taken up by the thin-film solar cell assembly, and includes, sequentially and from the top to the bottom, an upper surface layer, an adhesive bonding layer and a lower surface layer.

Optionally, the first flexible protection film layer includes, sequentially and from the top to the bottom, an adhesive bonding layer and a lower surface layer.

Optionally, the upper surface layer is an ETFE layer, the lower surface layer is a waterproof cloth, and the adhesive bonding layer is an EVA layer.

Optionally, the thickness of the upper surface layer ranges from 0.01 to 0.2 mm.

Optionally, the thickness of the adhesive bonding layer ranges from 0.2 to 0.3 mm.

Optionally, the thickness of the lower surface layer ranges from 0.1 to 0.2 mm.

Optionally, the power output device includes a junction box within which an integrated circuit board is arranged for controlling the electric energy converted by the thin-film solar cell assembly so that the output voltage of the foldable solar battery pack meets the requirements of a load, and the junction box is provided with at least one USB interface for connecting with the load.

Optionally, the integrated circuit board is provided with at least one indicator lamp which is capable of indicating light intensity.

Optionally, the wire is located between the first flexible protection film layer and the third flexible protection film layer and penetrates the adhesive bonding layer and the lower surface layer of the first flexible protection film layer to connect to the power output device.

Optionally, the thin-film solar cell assembly includes three thin-film solar cells arranged horizontally at equal intervals along the lengthwise direction of the inner surface of the expanded foldable pack body. A first fold line and a second fold line are formed between the three thin-film solar cells.

Optionally, the foldable solar battery pack further includes at least one fastener arranged on the foldable pack body and used for fastening the folded foldable pack.

Optionally, the foldable solar battery pack further includes at least one through hole arranged on the foldable pack body and used for hanging and connecting.

Optionally, the foldable solar battery pack further includes at least one storage bag arranged on the back side of the expanded foldable pack body.

Optionally, the at least one storage bag is connected to the back side of the expanded foldable pack body by a detachable connection member.

This application also provides a foldable solar battery pack including:
a foldable pack body formed by a first flexible protection film layer;
one or more thin-film solar cell assemblies arranged along a lengthwise direction of the inner surface of the expanded foldable pack body, wherein a gap is present in the foldable pack body and forms a fold line;
a power output device configured to output the electric energy converted by the thin-film solar cell assembly;
a wire configured for connecting the one or more thin-film solar cell assemblies and the power output device; and
a transparent flexible protection film layer configured to cover at least an upper surface of the thin-film solar cell assembly and fixed to the first flexible protection film layer.

Optionally, the foldable solar battery pack further includes:
a windowed flexible protection film layer provided with a window in the middle thereof to expose the upper surface of the thin-film solar cell assembly;
the portion of the windowed flexible protection film layer other than the window is fixed on the first flexible protection film layer, and the transparent flexible protection film layer is arranged to cover the upper surface of the thin-film solar cell assembly and is fixed on the windowed flexible protection film layer; or
the windowed flexible protection film layer is configured to fix the portion of the transparent flexible protection film layer extending beyond the upper surface of the thin-film solar cell assembly between the windowed flexible protection film layer and the first flexible protection film layer.

Optionally, the first flexible protection film layer includes, sequentially and from the top to the bottom, an adhesive bonding layer and a lower surface layer. The transparent flexible protection film layer includes, sequentially and from the top to the bottom, an upper surface layer and an adhesive bonding layer. The transparent flexible protection film layer is fixed on the lower surface layer of the first flexible protection film layer by the adhesive bonding layer or the adhesive bonding layer of the first flexible protection film layer.

Optionally, the first flexible protection film layer includes, sequentially and from the top to the bottom, an adhesive bonding layer and a lower surface layer, and the transparent flexible protection film layer includes, sequentially and from the top to the bottom, an upper surface layer and an adhesive bonding layer;
the portion of the windowed flexible protection film layer other than the window is fixed on the lower surface layer of the first flexible protection film layer by the adhesive bonding layer of the first flexible protection film layer, and the transparent flexible protection film layer is fixed on the thin-film solar cell assembly and the windowed flexible protection film layer by the adhesive bonding layer; or
the transparent flexible protection film layer is fixed on the thin-film solar cell assembly and the lower surface layer of the first flexible protection film layer by the adhesive bonding layer, and the portion of the transparent flexible protection film layer extending beyond the upper surface of the thin-film solar cell assembly is fixed between the windowed flexible protection film layer and the first flexible protection film layer.

Optionally, the upper surface layer of the transparent flexible protection film layer is an ETFE layer or ECTFE, the lower surface layer of the first flexible protection film layer and the windowed flexible protection film layer are waterproof cloths, the adhesive bonding layers of the first flexible protection film layer and the transparent flexible protection film layer are EVA layers, and the upper surface layer of the second flexible protection film layer is a layer provided with a plurality of recesses.

Optionally, the thickness of the upper surface layer of the transparent flexible protection film layer ranges from 0.01 to 0.2 mm, the thickness of the adhesive bonding layer of the transparent flexible protection film layer ranges from 0.2 to 0.3 mm, the thickness of the adhesive bonding layer of the first flexible protection film layer ranges from 0.2 to 0.3 mm, the thickness of the lower surface layer of the first flexible protection film layer ranges from 0.1 to 0.2 mm, and the thickness of the windowed flexible protection film layer ranges from 0.1 to 0.2 mm.

Optionally, three thin-film solar cell assemblies connected by wires are horizontally arranged along the length direction of the inner surface of the expanded foldable pack body, and a first fold line and a second fold line are formed between the three thin-film solar cell assemblies.

Compared with the prior art, the above technical schemes provided by the embodiments of the application have the following advantages.
1. The foldable solar battery pack provided by the embodiment of the application greatly improves the conversion efficiency of converting solar energy into electric energy by adopting the thin-film solar cell assembly. The thin-film solar cell is light in weight and easy to carry with. The foldable pack body is formed by a first flexible protection film layer through packaging. The second flexible protection film layer and the third flexible protection film layer are flexible, and the thin-film solar cell assembly fixed to the inner surface of the foldable pack body per se is also flexible, so that the portable foldable solar battery pack of the application can be folded to a smaller volume by the user and thus very easy to carry with. Furthermore, by the arrangement of the first, second and third flexible protection film layers, the thin-film solar cell assembly can be protected from moisture, high temperature and damages caused by external objects as well as mechanical and chemical damages, thus guaranteeing the reliability and stability of the portable foldable solar battery pack of the application.
2. The foldable solar battery pack provided by the embodiment of the application is provided with at least one indicator lamp on the integrated circuit board. The indicator lamp is capable of indicating the light intensity, and used for guiding users.
3. The foldable solar battery pack provided by the embodiment of the application is provided with a through hole on the foldable pack body, so that the solar charger can be conveniently hung on a backpack or a satchel when the user goes out, thereby further facilitating the user to carry the foldable solar battery pack with him/her.
4. The foldable solar battery pack provided by the embodiment of the application is provided with at least one storage bag on the back side of the expanded foldable pack body, and the storage bag can be used for containing a mobile device, such as a mobile phone, a tablet computer and the like.

### Brief Description of Drawings

In order that the disclosure of this application can be more clearly understood, embodiments of this application will be described in further detail below in accordance with specific embodiments of this application and with reference to the accompanying drawings, in which:
Fig. 1 is a front view of a portable foldable solar battery pack after being expanded according to an embodiment of the present application;
Fig. 2 is a back view of a portable foldable solar battery pack, without a storage bag, after being expanded according to an embodiment of the present application;
Fig. 3 is a back view of a portable foldable solar battery pack, with a storage bag, after being expanded according to an embodiment of the present application;
Fig. 4 is a longitudinal sectional view of a thin-film solar cell assembly.
Fig. 5 is a longitudinal sectional view of a foldable solar battery pack including the thin-film solar cell assembly portion according to a first embodiment;
Fig. 6 is a longitudinal sectional view of a foldable solar battery pack including the thin-film solar cell assembly portion according to a second embodiment.

The reference numbers in the figures are as follows: 1 - foldable pack body; 11 - through hole; 12 - first fold line; 13 - second fold line; 14 - snap fastener; 2 - thin-film solar cell assembly; 201 - water barrier film; 202 - adhesive bonding layer; 203 - thin-film solar cell chip; 204 - adhesive bonding layer; 205 - water barrier film; 31 - first flexible protection film layer; 311 - adhesive bonding layer; 312 - lower surface layer; 32 - second flexible protection film layer; 321 - upper surface layer; 322 - adhesive bonding layer; 3 - windowed flexible protection film layer; 201a - adhesive bonding layer, 203a - adhesive bonding layer; 4 - power output device; 41 - USB interface; 5 - wire; 6 - hook and loop fastener; 7 - storage bag.

### Detailed Description

The specific embodiments of the present application will be described in detail below with reference to the accompanying drawings. It should be understood that the specific embodiments described herein are only used to illustrate and explain the examples of this application and are not intended to limit the invention.

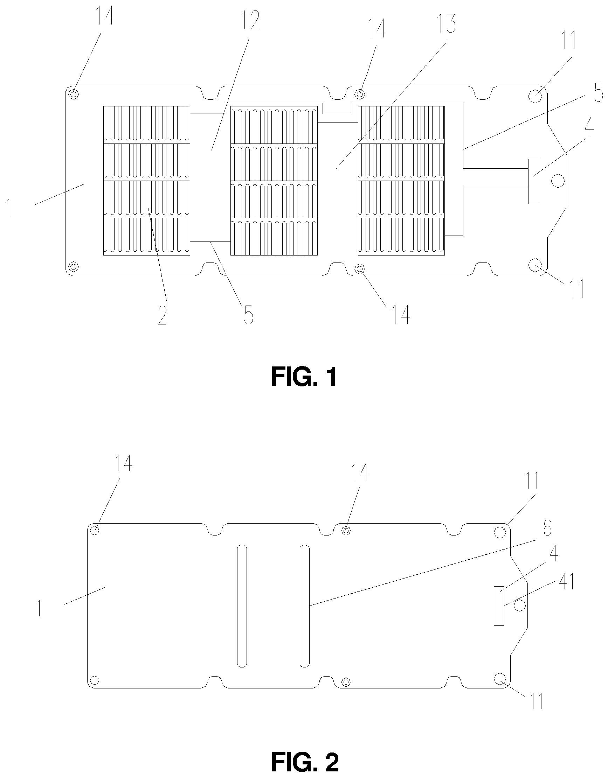

Fig. 1 shows the general technical disclosure of an embodiment, which provides a portable foldable solar battery pack including a foldable pack body 1, a thin-film solar cell assembly 2 for converting solar power into electrical energy, a power output device 4 for outputting the electrical energy converted by the thin-film solar cell assembly, and a wire 5 for connecting the thin-film solar cell assembly and the power output device.

The foldable pack body 1 is rectangular in shape after being expanded, or may be of other suitable shapes, and formed by a first foldable flexible protection film layer 31 through packaging. The thin-film solar cell assembly per se is flexible. Besides, the thin-film solar cell assembly has high conversion efficiency for converting solar energy into electric energy and the weight thereof is low. In an embodiment of the application, the thin-film solar cell assembly includes at least one thin-film solar cell assembly arranged along a lengthwise direction of the inner surface of the expanded foldable pack body. The thin-film solar cell is preferably a CIGS thin-film solar cell. A gap is present between any two adjacent thin-film solar cells and forms a fold line. In this embodiment, the thin-film solar cell assembly includes three CIGS thin-film solar cell assemblies 2 arranged horizontally at equal intervals along the lengthwise direction of the inner surface of the expanded foldable pack body 1. The three CIGS thin-film solar cell assemblies are connected in series through wires 5. A first fold line 12 and a second fold line 13 are formed between the CIGS thin-film solar cell assemblies 2. When users need to charge their mobile devices, such as mobile phones and tablet computers, the foldable solar battery pack is expanded along the first fold line 12 and the second fold line 13. The three CIGS thin-film solar cell assemblies 2 arranged on the expanded foldable pack body can absorb sufficient solar radiation and convert the solar radiation into electric energy, and then output the electric energy to the mobile device through the wires 5 and the power output device 4. When the user need not to charge his/her mobile device, the battery pack is folded into a smaller pack, which is easy to carry with, along the first fold line 12 and the second fold line 13. It should be noted that the embodiment of the present application does not limit the number of thin-film solar cells. The number of the CIGS thin-film solar cell assemblies can be appropriately adjusted according to actual need, for example, to four, five, or six, etc. It will be understood that the number of CIGS thin-film solar cell assemblies can also be one or two according to actual needs. Multiple CIGS thin-film solar cell assemblies can be connected in series or in parallel through wires according to actual needs. Each CIGS thin-film solar cell assembly includes one or more CIGS thin-film solar cells. The CIGS thin-film solar cell includes, sequentially and from the top to the bottom, a water barrier film 201, an adhesive bonding layer 202, a CIGS thin-film solar cell chip 203, an adhesive bonding layer 204, a water barrier film 205. The CIGS thin-film solar cell chip 203 has good flexibility, can be folded and curled, and will not be damaged after being folded or curled.

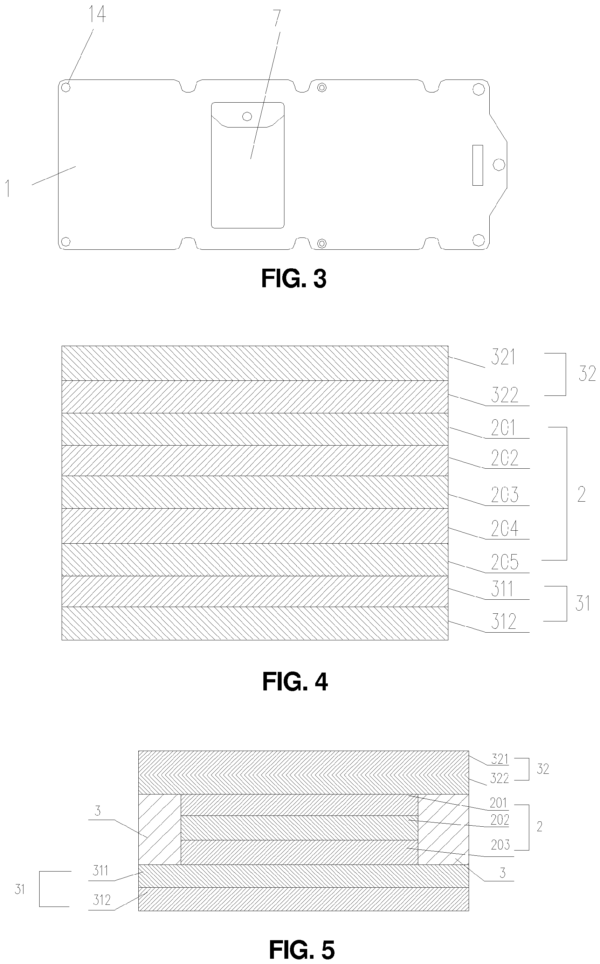

Optionally, as shown in Fig. 4, a second flexible protection film layer 32 is packaged on the thin-film solar cell assembly and includes, sequentially and from the top to the bottom, an upper surface layer 321 and an adhesive bonding layer 322. The upper surface layer 321 is made of a transparent, waterproof, scratchproof, wear-resistant and weather-resistant material, such as an ETFE layer. The adhesive bonding layer 322 is a hot melt adhesive layer such as an EVA layer. A third flexible protection film layer is packaged on the remaining area of the inner surface of the expanded foldable pack body expect for the area taken up by the thin-film solar cell assembly. The third flexible protection film layer includes, sequentially and from the top to the bottom, an upper surface layer, an adhesive bonding layer, a water-proof cloth, a water barrier film and an adhesive bonding layer. Likewise, the upper surface layer is made of a transparent, waterproof, scratchproof, wear-resistant and weather-resistant material, such as an ETFE layer, and the adhesive bonding layer is a hot melt adhesive layer such as an EVA layer. The lower surface layer is made of an opaque, flexible and waterproofed material such as waterproof cloth. The upper surface layer of the third flexible protection film layer can be bonded to the upper surface layer of the second flexible protection film layer. In this application, the thickness of the upper surface layer may range from 0.01 to 0.2 mm, and the packaging process is difficult to perform if it is too thick. Optionally, in an embodiment, the thickness of the upper surface layer is 0.05 mm. The thickness of the adhesive bonding layer may range from 0.2 to 0.3 mm, and the adhesive property is not good enough and stripping is prone to occur if it is too thin. The thickness of the lower surface layer may range from 0.1 to 0.2 mm.

By providing the second flexible protection film layer 32 and the third flexible protection film layer, the thin-film solar cell assembly can be protected from moisture, high temperature and damages caused by external objects as well as mechanical and chemical damages, thus guaranteeing the reliability and stability of the portable foldable solar battery pack of the embodiments.

Optionally, as shown in Fig. 4, the first flexible protection film layer 31 of this embodiment includes, sequentially and from the top to the bottom, an adhesive bonding layer 311 and a lower surface layer 312. Likewise, the adhesive bonding layer 311 is a hot melt adhesive layer such as an EVA layer, and the lower surface layer 312 is made of an opaque, flexible and waterproofed material such as waterproof cloth.

Optionally, the power output device 4 is a junction box within which an integrated circuit board is arranged for controlling the electric energy converted by the thin-film solar cell assembly 2 so that the output voltage meets the requirements of the load. The junction box is provided with at least one USB interface 41 for connecting with the load. The load can be mobile devices such as a mobile phone, a tablet computer, a notebook computer, a smart watch, a battery pack and the like.

For ease of use, the integrated circuit board of this embodiment is also provided with at least one indicator lamp which is capable of indicating light intensity and which is preferably an LED indicator lamp. In this embodiment, the LED indicator lamp is set to: emit red light when the sunlight is scarce; emit green light when the sunlight is sufficient and the load can be directly charged; and be off when the solar charger is turned off or there is no power left for charging the load, indicating that no power is being output. It should be noted that the indicating mode of the indicator lamp of the embodiment of the present application is not limited to the above-mentioned mode, and the indicating mode and result of the indicator lamp can be adjusted according to the actual needs of a user.

In this embodiment, the wire 5 is located between the third flexible protection film layer and the first flexible protection film layer 31 and penetrates the adhesive bonding layer 311 and the lower surface layer 312 of the first flexible protection film layer 31 to connect to the junction box 4. Optionally, the wire 5 is preferably a tinned woven copper strip.

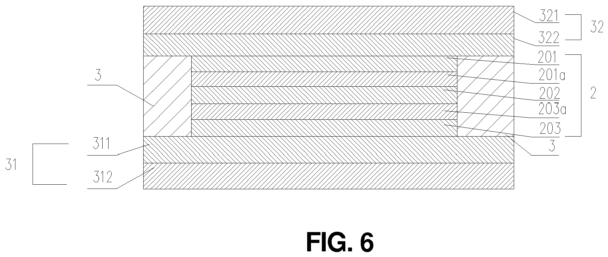

As an alternative embodiment of the present application, as shown in Fig. 5 or 6, the charger body 1 is formed through packaging by a first flexible protection film layer 31 which can be folded and curled. The first flexible protection film layer 31 includes, sequentially and from the top to the bottom, an adhesive bonding layer 311 and a lower surface layer 312. The adhesive bonding layer 311 is a hot melt adhesive layer such as an EVA layer, and the lower surface layer 312 is made of an opaque, flexible and waterproofed material such as waterproof cloth. Alternatively, the lower surface layer 312 is made of a transparent, waterproof, scratchproof, wear-resistant and weather-resistant material, such as an ETFE layer, ECTFE layer, or other materials that can meet such performance requirements.

The thin-film solar cell assembly 2 consists of one or more CIGS thin-film solar cells. Multiple CIGS thin-film solar cells are connected through wires and can be connected in series and/or in parallel according to actual needs. As shown in Fig. 5, the CIGS thin-film solar cell includes, sequentially and from the top to the bottom, a water barrier film 201, a CIGS thin-film solar cell chip 202, and a water barrier film 203. The CIGS thin-film solar cell chip 202 and the water barrier films 201 and 203 are packaged into one piece.

As an alternative embodiment, as shown in Fig. 6, the CIGS thin-film solar cell includes, sequentially and from the top to the bottom, a water barrier film 201, an adhesive bonding layer 201a, a CIGS thin-film solar cell chip 202, an adhesive bonding layer 203a and a water barrier film 203. The CIGS thin-film solar cell chip 202 and the water barrier film 201, the adhesive bonding layer 201a, the adhesive bonding layer 203a and the water barrier film 203 are packaged into one piece. The specific structure of the thin-film solar cell can be determined according to the specific CIGS thin-film solar cell chip.

The CIGS thin-film solar cell per se is flexible. Besides, the thin-film solar cell has high conversion efficiency for converting solar energy into electric energy and the weight thereof is low. The CIGS thin-film solar cell chip 202 has good flexibility, can be folded and curled, and will not be damaged after being folded or curled. The water barrier films 201 and 203 arranged respectively on the upper side and lower side of the CIGS thin-film solar cell chip 202 are waterproofed and electrically insulated. The water barrier film may be made of hot melt adhesive and is sticky. In this embodiment, the CIGS thin-film solar cell may have a rectangular or square shape.

In an embodiment of the application, one or more thin-film solar cell assemblies may be arranged horizontally along a lengthwise direction of the inner surface of the expanded foldable pack body, and fixed to the expanded first flexible protection film layer 31 by the adhesive bonding layer 311 of the first flexible protection film layer 31. A gap is present between any two adjacent thin-film solar cell assemblies and forms a fold line. In a preferable embodiment, three CIGS thin-film solar cell assemblies 2 may be arranged horizontally at equal intervals along the lengthwise direction of the inner surface of the expanded foldable pack body 1. The three CIGS thin-film solar cell assemblies are connected in series through wires 5. A first fold line 12 and a second fold line 13 are formed between the CIGS thin-film solar cell assemblies. When users need to charge their mobile devices, such as mobile phones and tablet computers, the foldable solar battery pack is expanded along the first fold line 12 and the second fold line 13. The three CIGS thin-film solar cell assemblies 2 arranged on the expanded foldable pack body can absorb sufficient solar radiation and convert the solar radiation into electric energy, and then output the electric energy to the mobile device through the wires 5 and the power output device 4. When the user would not charge his/her mobile device, the battery pack is folded into a smaller pack, which is easy to carry with, along the first fold line 12 and the second fold line 13.

It should be noted that the embodiment of the present application does not limit the number of thin-film solar cells or thin-film solar cell assemblies. The number of the CIGS thin-film solar cell assemblies can be appropriately adjusted according to actual needs, for example, to one, two, four, five, or six, etc. Each CIGS thin-film solar cell assembly can be formed by connecting one or more CIGS thin-film solar cells in series or in parallel. For example, one or two CIGS thin-film solar cell assemblies can be arranged on a portion of the inner surface of the foldable pack body, and the rest of the inner surface is left empty or arranged a mirror thereon. One or two fold lines are formed. After being folded, the portion left empty or the mirror can protect the CIGS thin-film solar cell assembly. Multiple CIGS thin-film solar cell assemblies can be connected in series or in parallel through wires 5 according to actual needs.

After the thin-film solar cell assembly 2 is fixed on the inner surface of the expanded first flexible protection film layer, a windowed flexible protection film layer 3 is laid. The windowed flexible protection film layer 3 has a window at the position corresponding to the upper surface of the thin-film solar cell assembly 2. In theory, the area of the window is preferably the same as that of the thin-film solar cell assembly 2, so as to sufficiently expose the thin-film solar cell assembly 2, thereby generate electric energy upon irradiation by the sun. If the area of the window is larger than the area of the thin-film solar cell assembly 2, there will be a gap between the windowed flexible protection film layer 3 and the thin-film solar cell assembly 2, adversely affecting the appearance. If the area of window is smaller than the area of the thin-film solar cell assembly 2, the windowed flexible protection film layer 3 will block the thin-film solar cell assembly, adversely affecting the power generation efficiency and reducing the power generation capacity. The windowed flexible protection film layer 3 is opaque, and can be made of waterproof cloth. Of course, the windowed flexible protection film layer 3 can also be made of ETFE, ECTFE or other suitable materials.

A second flexible protection film layer 32, which is a transparent flexible protection film layer, is arranged on the thin-film solar cell assembly 2 and the windowed flexible protection film layer 3. The second flexible protection film layer 32 includes, sequentially and from the top to the bottom, an upper surface layer 321 and an adhesive bonding layer 322. The upper surface layer 321 is preferably made of a transparent, waterproof, scratchproof, wear-resistant and weather-resistant material, such as an ETFE layer. The upper surface layer 321 can also be made of an ECTFE or other materials featured by transparent, waterproof, scratchproof, wear-resistant and weather-resistant. The adhesive bonding layer 322 is preferably a hot melt adhesive layer such as an EVA layer. The second flexible protective layer has a plurality of small recesses so as to reduce the reflection of sunlight and improve the efficiency of conversion of solar energy to electric energy.

Optionally, the area of the second flexible protection film layer 32 is at least greater than the surface area of each thin-film solar cell assembly 2 so as to be sufficiently bonded to the windowed flexible protection film layer 3 in order to protect thin-film solar cell assembly and its electrical connection components, such as junction box, wires, etc., from water, scratch, wear and the like. The area of the second flexible protection film layer 32 may be the same as the surface area of the first flexible protection film layer. Optionally, the second flexible protection film layer may extend to wrap around the foldable pack body to enhance the sealing property of the foldable solar battery pack.

As an alternative embodiment, the windowed flexible protection film layer 3 can be omitted, and the second flexible protection film layer 32 is directly laid on the thin-film solar cell assembly 2 and directly fixed to the lower surface layer 312 of the first flexible protection film layer 31 by the adhesive bonding layer 322. Or alternatively, after the second flexible protection film layer 32 is fixed to the lower surface layer 312 of the first flexible protection film layer 31 by the adhesive bonding layer 322, the windowed flexible protection film layer is laid on the second flexible protection film layer 32. With the latter case in which the windowed flexible protection film layer is used, the area of the second flexible protection film layer may be slightly larger than the surface area of each thin-film solar cell assembly 2, and the portion of the second flexible protection film layer 32 that goes beyond the surface area of the thin-film solar cell assembly 2 can be adhesively fixed between the windowed flexible protection film layer 3 and the first flexible protection film layer 31.

It will be understood that when the second flexible protection film layer 32 is fixed to the solar cell assembly 2 and the lower surface layer 312 of the first flexible protection film layer 31 by the adhesive bonding layer 322, the adhesive bonding portions of the second flexible protection film layer 32 and the first flexible protection film layer 31 can be one of the adhesive bonding layers 322 and 311, so as to avoid the adhesive bonding layer of the first and second flexible protection film layers 31 and 32 being too thick.

Optionally, the thickness of the upper surface layer 321 may range from 0.01 to 0.2 mm, and the packaging process is difficult to perform if it is too thick. In this embodiment, the thickness of the upper surface layer is 0.05mm. The thickness of the adhesive bonding layer may range from 0.2 to 0.3 mm, and the adhesive property is not good enough and stripping is prone to occur if it is too thin. The thickness of the lower surface layer may range from 0.1 to 0.2 mm. The thickness of the windowed flexible protection film layer may range from 0.1 to 0.2 mm.

The wires 5 are connected with the one or more thin-film solar cell assemblies and the power output device. When the foldable solar battery pack is provided with the windowed flexible protection film layer 3, the wires 5 are arranged between the windowed flexible protection film layer 3 and the first flexible protection film layer 31 and penetrate the adhesive bonding layer 311 and the lower surface layer 312 to connect to the junction box.

When the foldable solar battery pack is not provided with the windowed flexible protection film layer, the wires 5 may be arranged between the second flexible protection film layer 32 and the first flexible protection film layer 31 and penetrate the adhesive bonding layer 311 and the lower surface layer 312 to connect to the junction box.

Optionally, the wire 5 is preferably a tinned woven copper strip.

The arrangement of the power output device 4 and the LED may be set according to that described with respect to the above-mentioned embodiment.

In addition, the portable foldable solar battery pack provided by the embodiment further includes at least one fastener arranged on the foldable pack body and used for fastening the folded foldable pack. The fastener is preferably but not limited to a snap fastener 14 and may also be a hook and loop fastener, such as a nylon hook and loop fastener, or a magnetic fastener. Due to the arrangement of the fastener, the folded foldable pack would not be expanded, and thus easy to carry with.

The foldable pack body 1 is provided with at least one through hole 11 for hanging and connecting, and the through hole 11 is adapted to be arranged on the corner of the foldable pack body 1, so that through the through hole 11, a user can easily hang the portable foldable solar battery pack provided by the embodiment onto a bag carried with the user, such as a backpack, a satchel, and the like.

In addition, in order to facilitate the carrying of mobile devices, as shown in Fig. 3, the portable foldable solar battery pack provided in the embodiment of the application is provided with at least one storage bag 7 on the back side of the expanded foldable pack body 1. The storage bag 7 is used for containing mobile devices such as mobile phones, tablet computers and the like. In an embodiment, one storage bag is provided, and the size thereof is suitable for containing a mobile phone.

Optionally, as shown in Fig. 2, the storage bag is connected to the back side of the expanded foldable pack body 1 by a detachable connection member. As such, even when the foldable solar battery pack is in a folded state, the mobile phone can be put into or extracted from the storage bag. In this embodiment, the detachable connection member is a hook and loop fastener (Velcro) 6, but is not limited to the hook and loop fastener 6.

Obviously, the above-mentioned embodiments are only examples for clearly illustrating this application and are not intended to limit the application. For those skilled in the art, other different forms of changes or modifications can be made based on the above description. The embodiments described herein are not provided by an exhaustive way. Changes or modifications that can be conceived from the embodiments are still within the protection scope of the present invention.

### Industrial Applicability

The embodiments of this application provide a foldable solar battery pack which employs thin-film solar cell assembly and can improve the conversion efficiency of converting solar energy into electric energy. The foldable pack body is formed by a first flexible protection film layer through packaging. The second flexible protection film layer, the third flexible protection film layer or the windowed flexible protection film layer are flexible, and the thin-film solar cell assembly fixed on the inner surface of the foldable pack body per se is also flexible, so that the portable foldable solar battery pack can be folded and thus easy to carry with. The thin-film solar cell assembly can be protected from moisture, high temperature and damages caused by external objects as well as mechanical and chemical damages, thus guaranteeing the reliability and stability of the portable foldable solar battery pack of the application.

## Claims

1. A foldable solar battery pack comprising:
a foldable pack body (1) which is rectangular in shape after being expanded and is formed by a first flexible protection film layer (31) through packaging;
a thin-film solar cell assembly comprising at least one thin-film solar cell arranged along a lengthwise direction of the inner surface of the expanded foldable pack body, wherein a gap is present between any two adjacent thin-film solar cells and forms a fold line;
a power output device (4) configured to output the electric energy converted by the thin-film solar cell assembly; and
a wire (5) configured for connecting the thin-film solar cells and for connecting the thin-film solar cell assembly to the power output device (4);
wherein a second flexible protection film layer (32) is packaged on the thin-film solar cell assembly and comprises, sequentially and from the top to the bottom, an upper surface layer (321) and an adhesive bonding layer (322), and wherein a third flexible protection film layer is packaged on the remaining area of the inner surface of the expanded foldable pack body expect for the area taken up by the thin-film solar cell assembly, and comprises, sequentially and from the top to the bottom, an upper surface layer, an adhesive bonding layer and a lower surface layer.

2. The foldable solar battery pack according to claim 1, wherein the first flexible protection film layer (31) comprises, sequentially and from the top to the bottom, an adhesive bonding layer (311) and an lower surface layer (312).

3. The foldable solar battery pack according to claim 2, wherein the upper surface layer is an ETFE layer, the lower surface layer is a waterproof cloth, and the adhesive bonding layer is an EVA layer.

4. The solar charger according to any one of claims 1-3, wherein the thickness of the upper surface layer ranges from 0.01 to 0.2 mm.

5. The solar charger according to any one of claims 1-3, wherein the thickness of the adhesive bonding layer ranges from 0.2 to 0.3 mm.

6. The solar charger according to any one of claims 1-3, wherein the thickness of the lower surface layer ranges from 0.1 to 0.2 mm.

7. The foldable solar battery pack according to claim 1, wherein the power output device (4) comprises a junction box within which an integrated circuit board is arranged for controlling the electric energy converted by the thin-film solar cell assembly so that the output voltage of the foldable solar battery pack meets the requirements of a load, and wherein the junction box is provided with at least one USB interface for connecting with the load.

8. The foldable solar battery pack according to claim 7, wherein the integrated circuit board is provided with at least one indicator lamp which is capable of indicating light intensity.

9. The foldable solar battery pack according to claim 2, wherein the wire (5) is located between the first flexible protection film layer (31) and the third flexible protection film layer and penetrates the adhesive bonding layer (311) and the lower surface layer (312) of the first flexible protection film layer to connect to the power output device (4).

10. The foldable solar battery pack according to claim 1, wherein the thin-film solar cell assembly comprises three thin-film solar cells arranged horizontally at equal intervals along the lengthwise direction of the inner surface of the expanded foldable pack body, and wherein a first fold line (12) and a second fold line (13) are formed between the three thin-film solar cells.

11. The foldable solar battery pack according to claim 1, further comprising:
at least one fastener (14) arranged on the foldable pack body (1) and used for fastening the folded foldable solar battery pack.

12. The foldable solar battery pack according to claim 1, further comprising: at least one through hole (11) arranged on the foldable pack body and used for hanging and connecting.

13. The foldable solar battery pack according to any one of claims 1-3, further comprising: at least one storage bag arranged on the back side of the expanded foldable pack body.

14. The foldable solar battery pack according to claim 13, wherein the at least one storage bag is connected to the back side of the expanded foldable pack body by a detachable connection member.

15. A foldable solar battery pack comprising:
a foldable pack body (1) formed by a first flexible protection film layer (31);
one or more thin-film solar cell assemblies (2) arranged along a lengthwise direction of the inner surface of the expanded foldable pack body, wherein a gap is present in the foldable pack body and forms a fold line;
a power output device (4) configured to output the electric energy converted by the thin-film solar cell assembly;
a wire (5) configured for connecting the one or more thin-film solar cell assemblies and the power output device; and
a transparent flexible protection film layer (32) configured to cover at least an upper surface of the thin-film solar cell assembly and fixed on the first flexible protection film layer.

16. The foldable solar battery pack according to claim 15, further comprising:
a windowed flexible protection film layer (3) provided with a window in the middle thereof to expose the upper surface of the thin-film solar cell assembly;
wherein the portion of the windowed flexible protection film layer other than the window is fixed on the first flexible protection film layer, and the transparent flexible protection film layer is arranged to cover the upper surface of the thin-film solar cell assembly and is fixed on the windowed flexible protection film layer; or
the windowed flexible protection film layer is configured to fix the portion of the transparent flexible protection film layer extending beyond the upper surface of the thin-film solar cell assembly between the windowed flexible protection film layer and the first flexible protection film layer.

17. The foldable solar battery pack according to claim 15, wherein the first flexible protection film layer comprises, sequentially and from the top to the bottom, an adhesive bonding layer (311) and a lower surface layer (312); the transparent flexible protection film layer comprises, sequentially and from the top to the bottom, an upper surface layer (321) and an adhesive bonding layer (322), and wherein the transparent flexible protection film layer is fixed on the lower surface layer (312) of the first flexible protection film layer by the adhesive bonding layer (322) or the adhesive bonding layer (311).

18. The foldable solar battery pack according to claim 16, wherein the first flexible protection film layer (31) comprises, sequentially and from the top to the bottom, an adhesive bonding layer (311) and a lower surface layer (312); the transparent flexible protection film layer (32) comprises, sequentially and from the top to the bottom, an upper surface layer (321) and an adhesive bonding layer (322);
wherein the windowed flexible protection film layer is fixed on the lower surface layer (312) of the first flexible protection film layer (31) by the adhesive bonding layer (311) of the first flexible protection film layer, and the transparent flexible protection film layer (32) is fixed on the thin-film solar cell assembly and the windowed flexible protection film layer by the adhesive bonding layer (322); or
wherein the transparent flexible protection film layer (32) is fixed on the thin-film solar cell assembly and the lower surface layer (312) of the first flexible protection film layer by the adhesive bonding layer (322), and the portion of the transparent flexible protection film layer (32) extending beyond the upper surface of the thin-film solar cell assembly is fixed between the windowed flexible protection film layer and the first flexible protection film layer.

19. The foldable solar battery pack according to claim 17 or 18, wherein the upper surface layer of the transparent flexible protection film layer is an ETFE layer or ECTFE, the lower surface layer of the first flexible protection film layer and the windowed flexible protection film layer are waterproof cloths, the adhesive bonding layers of the first flexible protection film layer and the transparent flexible protection film layer are EVA layers, and the upper surface layer of the second flexible protection film layer is a layer provided with a plurality of recesses.

20. The foldable solar battery pack according to claim 17 or 18, wherein the thickness of the upper surface layer of the transparent flexible protection film layer ranges from 0.01 to 0.2 mm, the thickness of the adhesive bonding layer of the transparent flexible protection film layer ranges from 0.2 to 0.3 mm, the thickness of the adhesive bonding layer of the first flexible protection film layer ranges from 0.2 to 0.3 mm, the thickness of the lower surface layer of the first flexible protection film layer ranges from 0.1 to 0.2 mm, and the thickness of the windowed flexible protection film layer ranges from 0.1 to 0.2 mm.
